# FASCICULE DE BREVET EUROPEEN

(11) **EP 2 727 159 B1**
(45) Date de publication et mention de la délivrance du brevet: **26.08.2015**
(21) Numéro de dépôt: 12730966.4
(22) Date de dépôt: 29.06.2012
(51) Int. Cl.: H01L 41/29, H01L 41/313, B06B 1/06, G21C 17/025

(54) **Procédé de fabrication d'un traducteur ultrasonore haute température utilisant un cristal de niobate de lithium brasé avec de l'or et de l'indium**
Verfahren zur Herstellung eines Hochtemperatur-Ultraschallwandlers unter Verwendung eines mit Gold und Indium gelöteten Lithiumniobatkristalls
Method for manufacturing a high-temperature ultrasonic transducer using a lithium niobate crystal brazed with gold and indium

(30) Priorité: 30.06.2011 FR 1155880
(43) Date de publication de la demande: 07.05.2014
(73) Titulaire: Commissariat à l'Énergie Atomique et aux Énergies Alternatives, 75015 Paris (FR)
(72) Inventeur: LHUILLIER, Christian, F-13100 Aix En Provence (FR)
(74) Mandataire: Esselin, Sophie
(86) Numéro de dépôt international: PCT/EP2012/062675
(87) Numéro de publication internationale: WO 2013/001056

(56) Documents cités:
- BUTLER B ET AL: "Techniques for the generation of ultrasound for extended periods at high temperatures", ULTRASONICS, vol. 17, no. 6, novembre 1979 (1979-11), pages 249-254, XP025636694, ISSN: 0041-624X
- KAZYS R ET AL: "Development of ultrasonic sensors for operation in a heavy liquid metal", IEEE SENSORS JOURNAL, vol. 6, no. 5, octobre 2006 (2006-10), pages 1134-1143, XP009155767, ISSN: 1530-437X
- KRAUSE J T: "Gold-Indium Bond for Measurement of Ultrasonic Properties in Solids at High Temperatures", JOURNAL OF APPLIED PHYSICS, vol. 39, no. 11, 1968, pages 5334-5335, XP055017640, ISSN: 0021-8979, DOI: 10.1063/1.1655969

## Description

Le domaine de l'invention est celui des dispositifs émetteur, récepteur ou émetteur-récepteur d'ondes ultrasonores ou acoustiques pouvant se propager dans les solides et les fluides, dénommés ci-après dans la description : Traducteur UltraSonore Haute Température ou TUSHT, conçus pour fonctionner à de hautes températures, typiquement supérieures à plusieurs centaines de degrés Celcius.

De manière générale, les ondes acoustiques peuvent être de type longitudinal (propagation dans les fluides et les solides) ou de type transversal (propagation dans les solides et les fluides visqueux, par exemple), ou des combinaisons de ces deux types d'ondes (propagation d'ondes de surface, d'ondes guidées, dans les solides).

Actuellement il existe un besoin d'augmenter les domaines de fonctionnement des traducteurs ultrasonores ou acoustiques, et leur durée d'utilisation notamment dans les conditions physiques du collecteur chaud de la cuve principale de réacteurs à neutrons rapides refroidis par métal liquide.

Ce type de traducteurs peuvent en effet trouver des applications en réacteurs à neutrons rapides, le bon fonctionnement des traducteurs devant toutefois être visé sous notamment les conditions physiques indicatives suivantes :
- une immersion en métal ou alliage liquide (sodium par exemple) ;
- une température de travail en conditions normales: 200°C (réacteur à l'arrêt), 550°C (réacteur en fonctionnement) ;
- une température de travail en conditions incidentelles : 700°C ;
- des cycles de température entre 200°C et 550°C ;
- un gradient occasionnel de température (choc thermique) : - 20 °C/s entre 550 °C et 400 °C ;
- un flux de neutrons rapides et thermiques, et de photons gamma ;
- une durée de fonctionnement de plusieurs dizaines d'années (durée d'exploitation des réacteurs : 60 ans) ;
- une température d'épreuves (tests) ou de conditionnements initiaux supérieure à la température d'utilisation (600°C environ pour une utilisation à 550°C).

Les traducteurs doivent également pouvoir fonctionner à température ambiante (quelques degrés) pour les tests de laboratoire.

Les traducteurs doivent pouvoir fonctionner en émetteurs d'ondes acoustiques ou ultrasonores, en récepteurs d'ondes acoustiques ou ultrasonores, en émetteurs-récepteurs.

Les traducteurs doivent enfin pouvoir fonctionner dans un domaine étendu de fréquences acoustiques ou ultrasonores, typiquement du quasi continu à plusieurs Mégahertz.

Par leurs caractéristiques génériques, les améliorations des traducteurs visent également d'autres champs d'application tels que l'instrumentation des réacteurs à eau pressurisée ou bien encore l'instrumentation haute température dans l'industrie non nucléaire.

De manière connue, la génération et/ou la réception d'ondes acoustiques sont effectuées à l'aide d'un élément en matériau convertisseur d'énergie électrique en énergie mécanique et/ou inversement, de type piézoélectrique, ou magnétostrictif, ou électro-magnéto-acoustique (EMAT), ou autre.

L'élément convertisseur (de type piézoélectrique par exemple) est séparé du milieu de propagation des ondes par une lame de protection (généralement métallique ou en alliage métallique) appelée dans la description lame support (parfois nommée lame d'interface, lame de séparation, lame de phase, lame de couplage, lame avant, face avant, diaphragme, ....) ou plus généralement support, qui dans la pratique peut être intégré à une partie de boîtier ou d'une pièce à inspecter, ou d'un guide d'ondes.

Afin d'obtenir des performances satisfaisantes, il convient de déterminer notamment :
- le choix du matériau convertisseur ;
- le choix du matériau de support, et du plus généralement du boitier ;
- le choix et la mise en oeuvre du type de liaison (jonction) entre le matériau convertisseur et le support, cette liaison devant assurer, des fonctions mécaniques et acoustiques, c'est-à-dire être capable de transmettre des ultrasons dans une large plage de fréquence (du quasi continu à quelques Mégahertz) et de température (de quelques degrés à 550°C, voire 700°C). Sur sa deuxième face, le matériau convertisseur est couplé à une électrode, le couplage pouvant être effectué de la même manière qu'entre le matériau convertisseur et le support, ou pouvant être effectué de manière différente. Il peut en effet être intéressant que l'électrode ne soit pas couplée acoustiquement avec l'élément convertisseur. La lame peut servir de seconde électrode. Il est demandé au type de liaison d'être compatible avec la fonction électrique des électrodes (électrode et support, réalisés en matériaux conducteurs), c'est-à-dire qu'il n'introduise pas entre les électrodes et le convertisseur d'élément dont les propriétés électriques (résistivité) et/ou diélectriques puissent faire obstacle à un couplage électrique résistif et/ou capacitif, par exemple, par contact entre lesdites électrodes et le convertisseur.

L'ensemble suivant « support-première jonction-matériau convertisseur-seconde jonction-électrode », dénommé dans la suite de la description : assemblage, doit fonctionner (mécaniquement, électriquement et acoustiquement) durablement et avec des caractéristiques stables dans des conditions sévères énumérées précédemment.

Une technique parfois utilisée consiste à recourir à des guides d'ondes, dont une extrémité est au contact du milieu à haute température, l'autre extrémité étant située en zone plus froide et soumise à des flux nucléaires faibles, portant un traducteur conventionnel basse température. Ces dispositifs sont de mise en oeuvre délicate, notamment en présence de gradients et d'instabilités de température.

Il est à noter par ailleurs que les traducteurs ultrasonores dits « haute température » du commerce, ne permettent pas d'atteindre les performances demandées par rapport à la plage de température, la plage de fréquence, et la durée d'utilisation. En effet les limitations sont apportées notamment par :
- le matériau convertisseur piézoélectrique de température de Curie insuffisamment élevée, par exemple ;
- le type de jonction utilisée entre ce matériau et la lame (boitier) : colles, pâtes, joints liquéfiables..., ne supportant pas la température imposée ou des cycles ou gradients de température, ou ne supportant pas les contraintes mécaniques induites par la température ou le fonctionnement du traducteur, ou bien encore dégradant le traducteur par agressivité ou réactions chimiques, ... ;
- le type de jonction utilisée entre ce matériau et la lame ; le contact sec par pression (vis, ressort) par exemple n'est pas adapté à la transmission d'ultrasons de haute fréquence.

De plus, les matériaux utilisés (convertisseur, jonction) sont souvent fragilisés par les conditions de rayonnements nucléaires.

C'est pourquoi, la présente invention a pour objet un procédé de fabrication d'un traducteur ultrasonore haute température, ledit traducteur comprenant une électrode supérieure en acier ou métal, un convertisseur en matériau piézoélectrique et un support en acier ou métal assurant l'interface entre le convertisseur et le milieu de propagation des ondes acoustiques, une première jonction entre le support et le cristal piézoélectrique, une seconde jonction entre le convertisseur et l'électrode supérieure, caractérisé en ce qu'il comprend les étapes suivantes pour réaliser lesdites jonctions :
- le dépôt d'une couche d'or suivi du dépôt d'une couche d'indium sur l'une des faces de l'électrode supérieure, sur les deux faces du convertisseur et sur une face du support en acier ;
- l'empilement du support, du convertisseur, et de l'électrode supérieure, maintenu sous pression ;
- la réalisation de la première jonction et de la seconde jonction à base de composés d'or et d'indium, par une opération de brasage et de diffusion;
- ladite opération de brasage et de diffusion comportant les étapes suivantes :
   ▪ une première étape de montée en température à une première température comprise entre environ 150°C et environ 400°C et le maintien à cette première température pendant une première durée correspondant à un premier palier ;
   ▪ une deuxième étape de montée en température à une seconde température comprise entre environ 400°C et environ 1000°C et le maintien à cette seconde température pendant une seconde durée correspondant à un second palier.

L'invention a aussi pour objet un procédé de fabrication d'un traducteur ultrasonore haute température, ledit traducteur comprenant une électrode supérieure en acier ou métal, un convertisseur en matériau piézoélectrique et un support en acier ou métal assurant l'interface entre le convertisseur et le milieu de propagation des ondes acoustiques, une première jonction entre le support et le cristal piézoélectrique, une seconde jonction entre le convertisseur et l'électrode supérieure, caractérisé en qu'il comprend en outre les étapes suivantes pour réaliser lesdites jonctions :
- le dépôt d'une couche d'or suivi du dépôt d'une couche d'indium sur une première face du convertisseur et sur une face du support en acier ;
- la seconde face du convertisseur étant indifféremment du traitement effectué sur la face de l'électrode, laissée nue ou recouverte d'une couche d'or suivie d'une couche d'indium ou recouverte d'une couche d'or, ou de tout autre matériau, de préférence non oxydable, et dont les propriétés électriques et diélectriques sont compatibles avec un couplage électrique résistif et/ou capacitif, par exemple, du convertisseur et de l'électrode par contact ;
- la face de l'électrode pouvant être indifféremment du traitement effectué sur la seconde face du convertisseur, laissée nue ou recouverte d'une couche d'or suivie d'une couche d'indium ou recouverte d'une couche d'or, ou de tout autre matériau, de préférence non oxydable, et dont les propriétés électriques et diélectriques sont compatibles avec un couplage électrique résistif et/ou capacitif, par exemple, de l'électrode et du convertisseur par contact ;
- l'empilement du support et du convertisseur maintenu sous pression, ladite première face du convertisseur étant en regard dudit support ;
- la réalisation de la première jonction à base de composé d'or et d'indium, par une opération de brasage et de diffusion ;
- ladite opération de brasage et de diffusion comportant les étapes suivantes :
   ▪ une première étape de montée en température à une première température comprise entre environ 150°C et environ 400°C et le maintien à cette première température pendant une première durée correspondant à un premier palier ;
   ▪ une deuxième étape de montée en température à une seconde température comprise entre environ 400°C et environ 1000°C et le maintien à cette seconde température pendant une seconde durée correspondant à un second palier.
- l'empilement de l'électrode supérieure sur le convertisseur ;
- la réalisation de la seconde jonction par contact entre le convertisseur et l'électrode supérieure.

Ainsi, selon la présente invention, le fait d'effectuer dans l'opération de brasage et de diffusion, un premier palier à « moyenne » température, puis un second palier à « haute » température permet d'assurer une très bonne qualité de jonction particulièrement bien adaptée aux applications visées dans la présente demande.

Selon une variante de l'invention, le matériau piézoélectrique est du niobate de lithium.

Le niobate de lithium peut se présenter sous toutes ses formes, compositions chimiques et traitements, par exemple : niobate de lithium monocristallin ou polycristallin, congruent, stoechiométrique ou quasi stoechiométrique, réduit (« black lithium niobate »), à domaines de polarisation alternés ou inversés, à polarisation périodique (PPL, periodically poled lithium niobate), dopé (inclusion ou substitution d'éléments chimiques) ; le niobate de lithium peut être élaboré par toute technique dont, par exemple : le tirage par méthode Czochralski ou Czochralski modifiée, l'élaboration par fusion de zone, l'élaboration par procédé sol-gel.

Selon une variante de l'invention, le pourcentage atomique de l'indium est inférieur à environ 35 %.

Selon une variante de l'invention, le niobate de lithium est un niobate naturel ou un niobate enrichi en isotope 7 du lithium.

Selon une variante de l'invention, le niobate de lithium présente une coupe d'orientation Z (Y 90°).

Selon une variante de l'invention, le niobate de lithium présente une coupe d'orientation Y 36° ou une coupe d'orientation Y 163°.

Selon une variante de l'invention, ladite première température est supérieure à la température de fusion de l'indium pur.

Selon une variante de l'invention, ladite première température est de l'ordre de 170 °C.

Selon une variante de l'invention, ladite seconde température est de l'ordre de 650 °C.

Selon une variante de l'invention, la première température est légèrement ascendante durant la première durée.

Selon une variante de l'invention, la première durée est de l'ordre de 1 heure, la seconde durée étant de l'ordre de 2 heures, la montée en température entre ladite première température et ladite seconde température étant de l'ordre de 4 heures.

Selon une variante de l'invention, les étapes de réalisation des jonctions brasées sont effectuées sous un vide secondaire pouvant être de l'ordre de 10⁻⁵ mbar.

Selon une variante de l'invention, les étapes de réalisation des jonctions brasées sont effectuées en maintenant l'assemblage sous une contrainte de pression modérée, qui peut être inférieure à environ 2 kg/cm².

Selon une variante de l'invention, le procédé comprend l'intégration de l'assemblage : support-première jonction-convertisseur-seconde jonction-électrode supérieure dans un boîtier, ledit support étant une lame intégrée audit boîtier.

Selon une variante de l'invention, ledit boîtier comprend des moyens d'aération permettant de renouveler la teneur en oxygène présente dans ledit boîtier.

Selon une variante de l'invention, le procédé comprend en outre pour réaliser les jonctions brasées :
- l'assemblage de l'ensemble constitué par l'électrode supérieure, le convertisseur et le support, ou le convertisseur et le support, en présence de feuille intercalée à base d'or et d'indium, ou de mélanges d'or et d'indium, entre chacun des éléments précités ;
- une opération de brasage et diffusion.

Selon une variante de l'invention, le procédé comprend en outre la réalisation de couches préalables d'or sur les faces desdits éléments destinés à être en regard dans l'opération d'assemblage par brasage, de manière à favoriser l'adhérence desdites feuilles à base d'or et d'indium, ou de mélange d'or et d'indium.

Selon une variante de l'invention, les dépôts de couches sont réalisés par pulvérisation cathodique.

Selon une variante de l'invention, le procédé comprend en outre, préalablement aux dépôts de couches d'or, la réalisation de couches d'accrochage sur les faces de l'électrode et/ou du convertisseur et/ou du support.

La couche d'accrochage peut également faire office de barrière par rapport à la migration des éléments or et/ou indium dans les matériaux situés de part et d'autre des jonctions, lors des dépôts et/ou dans les conditions de température et de pression précédant les opérations de brasage. Ceci permet ainsi d'éviter que les dépôts pénètrent dans les matériaux avant le brasage.

Selon une variante de l'invention, la ou les couches d'accrochage sont à base de chrome et/ou de chrome et de nickel ou de titane.

Selon une variante de l'invention, le procédé comprend en outre, le dépôt d'une couche de protection sur la couche d'indium.

Selon une variante de l'invention, la couche de protection est à base d'or.

L'invention sera mieux comprise et d'autres avantages apparaîtront à la lecture de la description qui va suivre donnée à titre non limitatif et grâce aux figures annexées parmi lesquelles :
- les figures 1a et 1b illustrent un premier exemple de réalisation d'un traducteur selon l'invention ;
- les figures 2a et 2b illustrent des exemples de cycles de brasage permettant d'obtenir les jonctions présentes dans un traducteur de la présente invention ;
- la figure 3 illustre un second exemple de réalisation d'un traducteur selon l'invention, comprenant l'utilisation de feuille intercalaire ;
- la figure 4 illustre un dispositif comprenant un traducteur de l'invention et des moyens permettant de le faire fonctionner à des températures atteignant couramment 530°C à 600°C, la température limite de fonctionnement de l'assemblage support-convertisseur-électrode étant supérieure à 900°C.

La présente invention va être décrite dans le cadre de la réalisation d'un traducteur ultrasonore intégré dans un boîtier et notamment pour être utilisé pour réaliser de la détection de défauts d'objets, de présence de bulles de gaz, etc..., dans du sodium, milieu opaque ne permettant pas de détection optique, ou pour réaliser la détection de bruits.

L'intérêt de la présente invention réside notamment dans les matériaux constitutifs des jonctions réalisées par brasage qui permettent la transmission d'ondes acoustiques dans une large bande de fréquences.

### Premier exemple de réalisation d'un assemblage utilisé dans un traducteur de l'invention :

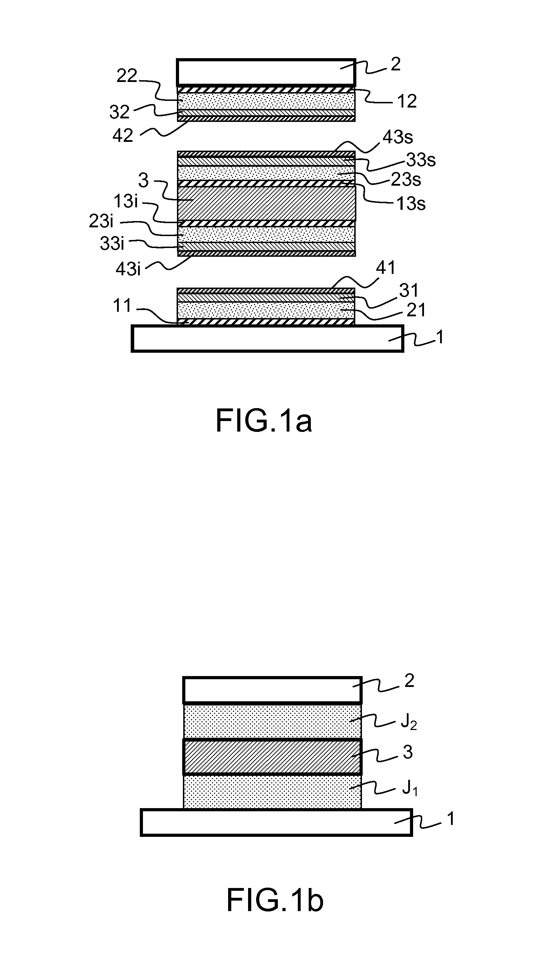

On réalise les empilements de couches suivants sur chacun des éléments : support, convertisseur, électrode supérieure, ledit support correspondant à la lame d'un boitier. Ainsi, comme illustré en figure 1 :
Un support 1 est recouvert d'un empilement de couches constitué des couches suivantes :
   - une couche d'accrochage 11 ;
   - une couche d'or 21 ;
   - une couche d'indium 31 ;
   - une couche de protection 41.

Une électrode supérieure 2 comprend également l'empilement de couches suivant :
- une couche de protection 42 :
- une couche d'indium 32 ;
- une couche d'or 22 ;
- une couche d'accrochage 12.

Un convertisseur pouvant être constitué d'un cristal piézoélectrique 3 comprend sur sa face inférieure l'empilement de couches suivant :
- une couche de protection 43i ;
- une couche d'indium 33i ;
- une couche d'or 23i ;
- une couche d'accrochage 13i
et en face supérieure, un empilement symétrique de couches, soit :
- une couche d'accrochage 13s ;
- une couche d'or 23s ;
- une couche d'indium 33s ;
- une couche de protection 43s.

Avantageusement le support de type lame et l'électrode dite supérieure peuvent être en acier de diverses nuances, l'acier le plus couramment utilisé étant l'acier austénitique de type 304L (éventuellement refondu sous vide).

Après assemblage, on obtient la structure de traducteur illustré en figure 1b qui met en évidence les premières et seconde jonctions J₁ et J₂ situées respectivement entre le support et le convertisseur d'une part et entre le convertisseur et l'électrode supérieure d'autre part.

Le convertisseur peut être un disque de :
- niobate de lithium monocristallin, congruent, en coupe cristallographique dite Z (axe du disque parallèle à l'axe « optique » du cristal), élaboré par la technique de croissance dite de tirage « Czochralski », les faces planes des disques de niobate de lithium sont initialement polies ou doucies ;
- niobate de lithium naturel permettant des fonctionnements à haute température (limite théorique de 1140°C environ) ;
- niobate de lithium enrichi en lithium 7, élaboré à partir de carbonate de lithium enrichi en lithium 7, de teneur isotopique en lithium 7 supérieure à 99,9%, et d'oxyde de niobium naturel et permettant de surcroît des fonctionnements sous fluence de neutrons élevée ;
- niobate de lithium (naturel ou enrichi en lithium 7) pouvant avoir subi, avant la croissance du cristal, un procédé thermique destiné à éliminer le gaz CO₂ des produits de base.

Il est à noter que l'utilisation d'acier de type 304L et de la coupe cristallographique dite Z permet d'assembler favorablement ces deux matériaux par brasage, les valeurs des coefficients de dilatation thermique étant suffisamment proches dans le plan de la jonction.

Avantageusement, les dépôts successifs des quatre couches sur chacun des éléments peuvent être effectués par pulvérisation cathodique sous vide, et ce dans un même cycle, le vide n'étant pas rompu entre les différentes phases de dépôts.

Les dépôts (nature, épaisseurs) sont identiques sur chacune des faces à assembler par brasage pour des raisons de symétrie, les épaisseurs pouvant également ne pas être identiques.

Deux exemples d'empilement de couches métalliques sont donnés ci-après, la première couche étant celle déposée sur le support ou le convertisseur ou l'électrode.

### Exemple A :

| Couche | Fonction | Matériau | Epaisseur (µm) |
|---|---|---|---|
| 1ère couche | Accrochage | Chrome | 0,05 |
| 2ème couche | Brasure | Or | 5 |
| 3ème couche | Brasure | Indium | 2 |
| 4ème couche | Protection | Or | 0,1 |

### Exemple B :

| Couche | Fonction | Matériau | Epaisseur (µm) |
|---|---|---|---|
| 1ère couche | Accrochage | Nikel-Chrome 80-20 | 0,05 |
| 2ème couche | Brasure | Or | 5 |
| 3ème couche | Brasure | Indium | 2 |
| 4ème couche | Protection | Or | 0,15 |

Les jonctions J₁ et J₂ sont élaborées grâce au cycle de brasage effectué dans les conditions suivantes :
- les pièces à assembler sont positionnées face métallisée contre face métallisée, et maintenues par pression modérée (la valeur couramment utilisée est de quelques 10² g/cm², inférieure à 2 kg/cm², pour des convertisseurs de diamètre 40 et 15 mm) pendant toute la durée du cycle ;
- les pièces ainsi positionnées sont soumises à un cycle de brasage dans un four, sous vide (soit à une pression inférieure ou égale à 3x10⁻⁵ torr, soit 4x10⁻⁵ mbar ou 4x10⁻³ Pa), sans flux gazeux ;

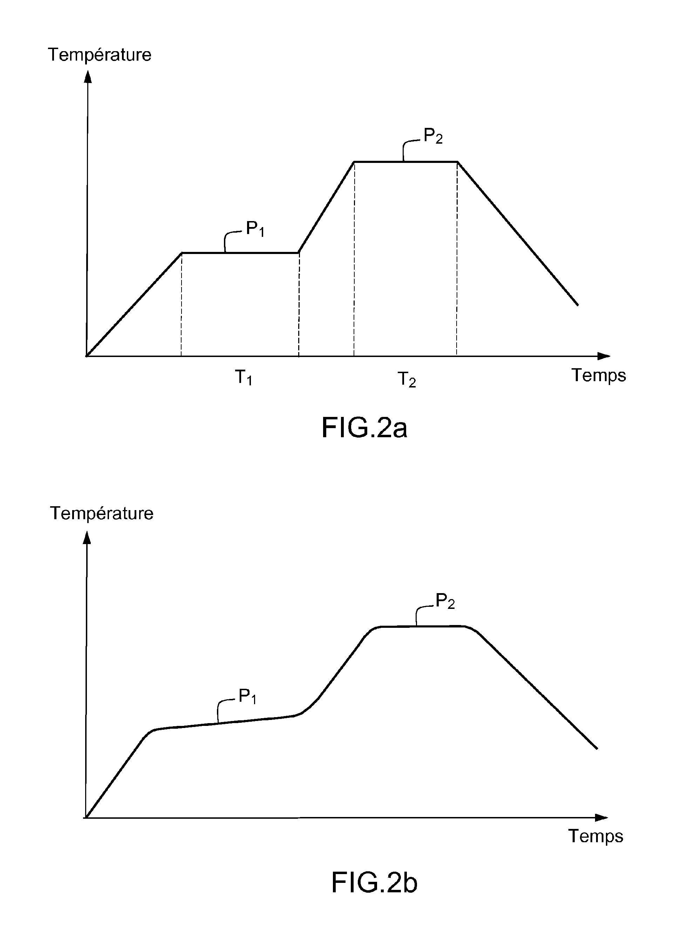

Le cycle de brasage comporte deux paliers de température illustrés en figure 2a, successivement :
- un premier palier P1 permettant notamment la fusion de l'indium, à basse température : 170°C, de durée T1 égale à 1 heure, le maintien de ce palier permettant aussi les dégazages ;
- une rampe de température entre 170°C et 650°C, de durée 4 heures ;
- un second palier P2, à haute température : 650°C, de durée T2 égale à 2 heures ;
- une descente progressive en température.

Une variante de cycle de brasure est illustré en figure 2b. Il est à noter en effet qu'il est également possible d'effectuer les cycles de brasure par montées progressives et non paliers stricts.

Il est également possible d'effectuer des paliers intermédiaires pour favoriser la mise en équi-température des pièces à braser.

De manière générale, les quatre couches métalliques sont déposées successivement sans rompre le vide entre deux dépôts successifs, et les dépôts (natures, épaisseurs) sont identiques sur les deux pièces à assembler par brasage pour des raisons de symétrie, sans que l'égalité des épaisseurs des couches soit une nécessité.

Les épaisseurs d'indium et d'or destinées à former la couche finale d'or et d'indium de jonction, peuvent avantageusement être dans le rapport 2/5, correspondant à un pourcentage théorique d'indium (indium/(indium + or)) de l'ordre de 13% en masse et de 20 % en nombre d'atomes.

Les spécificités de composition or-indium et de température-durée de brasage procurent à l'assemblage brasé une température de fusion et désolidarisation, donc dans la pratique une température maximale d'utilisation, plus élevée que celle des méthodes de liaison à base d'or-indium qui utilisent des rapports indium/or plus importants et qui se limitent au palier « basse température » de fusion de l'indium, à des températures proches de celui du palier P1, pour lesquelles la température de fusion et de désolidarisation de l'assemblage est insuffisante pour les applications citées précédemment.

### Second exemple de réalisation d'un assemblage utilisé dans un traducteur selon l'invention :

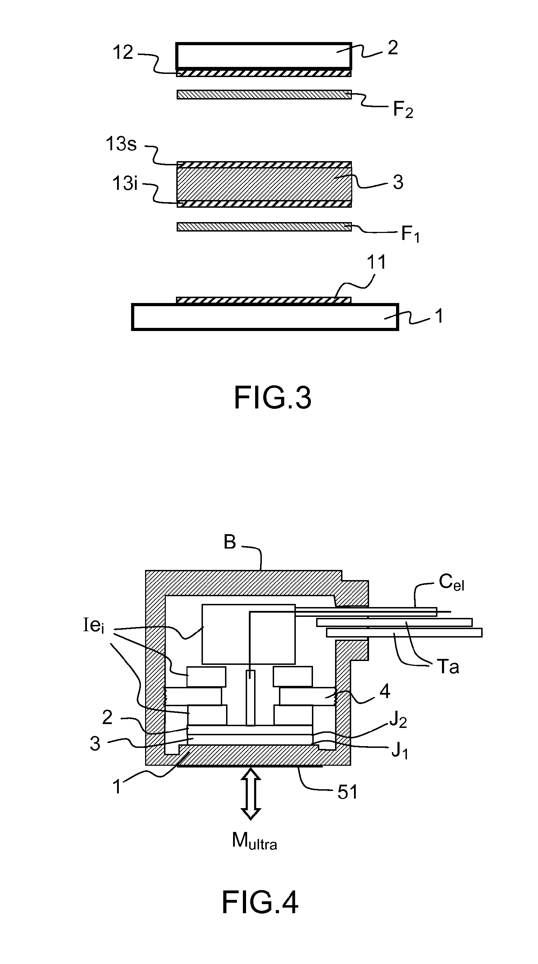

On réalise sur une face du support 1, sur les deux faces du convertisseur 3 et sur une face de l'électrode supérieure 2, le dépôt d'une couche d'or (après dépôt initial d'une couche d'accrochage, non représentée sur la figure 3) respectivement 11, 13i, 13s et 12 comme illustré en figure 3 et on intercale des feuilles d'or et d'indium (feuille d'indium insérée entre deux feuilles d'or), ou de mélange d'or et d'indium, F1 et F2 entre ces différents éléments (sur la figure 3, F1 et F2 peuvent représenter un ensemble de feuilles). Typiquement l'épaisseur de feuilles d'indium et d'or peut être de l'ordre d'une dizaine de micromètres.

On peut alors procéder à l'un des cycles de brasage précédemment décrit afin d'obtenir le traducteur comprenant les deux jonctions J1 et J2 à base d'or et d'indium.

### Exemple de traducteur TUSHT de l'invention :

Les assemblages précédemment décrits peuvent avantageusement être intégrés dans un traducteur ultrasonore TUSHT tel que celui représenté en figure 4 et destiné à pouvoir fonctionner à des températures très élevées, potentiellement de l'ordre de 900 à 1000 °C, permettant d'envisager des applications dans la cuve principale d'un réacteur nucléaire à neutrons rapides refroidi au sodium, dans tous ses régimes de fonctionnement.

Le convertisseur 3 comprend un disque piézoélectrique de niobate de lithium plan pouvant typiquement avoir un diamètre de 40 mm ou 15 mm ou 6 mm et d'épaisseur 0,78 mm.

La lame en acier 1 est plane, et peut être d'épaisseur 1,2 mm. Cette valeur habituelle n'est pas limitative, elle est néanmoins contrainte par l'obligation de tenue de longue durée en sodium.

L'électrode 2 est également en acier et plane, d'épaisseur habituellement comprise entre 1 et 2 mm, ces valeurs n'étant pas limitatives.

La lame est soudée à un boîtier B également en acier.

Le traducteur est équipé d'un câble électrique Cₑₗ, de type coaxial par exemple), dont l'âme est soudée à l'électrode et la gaine externe en acier est soudée au boîtier et donc électriquement reliée à la lame.

Un écrou 4, vissé dans le boîtier, peut venir en appui sur l'électrode via une rondelle réalisée dans un matériau électriquement isolant (de la stumatite par exemple. Cet écrou peut être remplacé par tout dispositif (ressort, ...), réalisant la même fonction.

L'écrou 4 a pour but de :
- s'opposer à des déformations de la lame pouvant endommager l'assemblage sous l'action d'une pression extérieure par exemple. Le dimensionnement de l'écrou est qualifié dans les conditions physiques de température et de pression représentatives d'une cuve de réacteur à eau pressurisée (170 bars, 320°C). L'écrou n'est pas nécessaire pour un fonctionnement dans les conditions normales de la cuve principale d'un réacteur à neutrons rapides refroidi au sodium liquide (sous faible pression, le dimensionnement garantit un fonctionnement sous 550°C et 40 bars) ;
- d'appuyer l'électrode sur l'élément piézoélectrique dans la version à électrode non brasée (continuité électrique par contact résistif et/ou capacitif).

Le nombre, la position et l'amortissement des fréquences de résonance sont ajustés en modifiant les épaisseurs des matériaux qui sont couplés acoustiquement : lame, élément piézoélectrique, électrode ou lame et élément piézoélectrique, selon les variantes.

Un TUSHT peut posséder simultanément plusieurs fréquences de résonance (chacune possédant sa propre bande passante) et être utilisé indifféremment ou simultanément sur chacune de ces fréquences, en émetteur-récepteur par exemple, avec comme incidences :
- la possibilité d'effectuer des mesures sous diverses échelles de résolution axiale ou latérale (directivité), celles-ci étant liées à la fréquence, via la longueur d'onde des signaux,
- la possibilité d'effectuer les mesures à la (les) fréquence(s) la (les) mieux appropriée(s) en fonction de l'atténuation des ondes acoustiques par le milieu de propagation, laquelle dépend en général de la fréquence et laquelle peut être une donnée variable.

Dans le dimensionnement standard, les TUSHT brasés sont utilisables en émetteur, en récepteur, en émetteur-récepteur dans un domaine étendu de fréquence (jusqu'à 5 MHz au moins).

Avantageusement, le boîtier est en outre équipé de tubes d'aération Ta, et d'isolants électriques Iₑᵢ. Une fine couche d'or 51 peut être prévue en extérieur du boitier côté lame 1, afin de faciliter le mouillage (au sens acoustique de la transmission des ultrasons) par le milieu de propagation des ondes ultrasonores Mᵤₗₜᵣₐ, si celui-ci est du sodium liquide à basse température (inférieure à 350°C) par exemple.

Le traducteur de la présente invention peut également avantageusement comprendre :
- des assemblages multi-strates, comprenant un ou plusieurs disques piézoélectriques associés selon le modèle Tonpiltz, sous contrainte mécanique, dans le but d'augmenter le rendement du traducteur (application aux techniques d'acoustique non linéaire), éventuellement en association avec une lame focalisante.

Il peut être également intéressant d'assembler des traducteurs multiéléments (composés de pavés juxtaposés), utilisables dans des dispositifs de type imagerie mettant en oeuvre des procédés de traitement électronique ou informatique des signaux des divers éléments (sommations, combinaisons, retards, ...).

La réalisation peut être obtenue de diverses manières et par exemple :
- en réalisant initialement un assemblage brasé classique (monoélément) support-convertisseur-électrode, puis définition des pavés par usinage d'encoches (par sciage mécanique ou par tout autre procédé) dans l'épaisseur de l'assemblage (encoches traversant au moins l'électrode, voire l'élément piézoélectrique et pénétrant dans la lame) ;
- en réalisant initialement un assemblage monoélément support-convertisseur-électrode dont les métallisations de brasage (sur l'élément piézoélectrique, voire sur la lame et l'électrode) sont limitées (par techniques de masques,...) à des pavés définissant les éléments du traducteur, puis séparation mécanique des pavés par usinage d'encoches ;
- par brasage individuel des pavés préalablement découpés (matériau piézoélectrique et électrodes).

Enfin il est à noter que la technique d'assemblage par brasage est adaptable à diverses géométries : axisymétriques de révolution (disques), plaques (parallélépipèdes, par exemple).

## Revendications

1. Procédé de fabrication d'un traducteur ultrasonore haute température, ledit traducteur comprenant une électrode supérieure (2) en acier ou métal, un convertisseur (3) en matériau piézoélectrique et un support (1) en acier ou métal assurant l'interface entre le convertisseur et le milieu de propagation des ondes acoustiques, une première jonction (J₁) entre le support et le matériau piézoélectrique, une seconde jonction (J₂) entre le convertisseur et l'électrode supérieure, **caractérisé en ce qu'**il comprend les étapes suivantes pour réaliser lesdites jonctions :
- le dépôt d'une couche d'or suivi du dépôt d'une couche d'indium sur l'une des faces de l'électrode supérieure, sur les deux faces du convertisseur et sur une face du support en acier ;
- l'empilement du support, du convertisseur, et de l'électrode supérieure, maintenu sous pression ;
- la réalisation de la première jonction et de la seconde jonction à base de composés d'or et d'indium, par une opération de brasage et de diffusion ;
- ladite opération de brasage et de diffusion comportant les étapes suivantes :
▪ une première étape de montée en température à une première température comprise entre environ 150°C et environ 400°C et le maintien à cette première température pendant une première durée correspondant à un premier palier ;
▪ une deuxième étape de montée en température à une seconde température comprise entre environ 400°C et environ 1000°C et le maintien à cette seconde température pendant une seconde durée correspondant à un second palier.

2. Procédé de fabrication d'un traducteur ultrasonore haute température, ledit traducteur comprenant une électrode supérieure (2) en acier ou métal, un convertisseur (3) en matériau piézoélectrique et un support (1) en acier ou métal assurant l'interface entre le convertisseur et le milieu de propagation des ondes acoustiques, une première jonction (J₁) entre le support et le matériau piézoélectrique, une seconde jonction (J₂) entre le convertisseur et l'électrode supérieure, caractérisé en qu'il comprend en outre les étapes suivantes pour réaliser lesdites jonctions :
- le dépôt d'une couche d'or suivi du dépôt d'une couche d'indium sur une première face du convertisseur et sur une face du support en acier ;
- la seconde face du convertisseur étant indifféremment du traitement effectué sur la face de l'électrode, laissée nue ou recouverte d'une couche d'or suivie d'une couche d'indium ou recouverte d'une couche d'or, ou de tout autre matériau, de préférence non oxydable, et dont les propriétés électriques et diélectriques sont compatibles avec un couplage électrique résistif et/ou capacitif, par exemple, du convertisseur et de l'électrode par contact ;
- la face de l'électrode pouvant être indifféremment du traitement effectué sur la seconde face du convertisseur, laissée nue ou recouverte d'une couche d'or suivie d'une couche d'indium ou recouverte d'une couche d'or, ou de tout autre matériau, de préférence non oxydable, et dont les propriétés électriques et diélectriques sont compatibles avec un couplage électrique résistif et/ou capacitif, par exemple, de l'électrode et du convertisseur par contact ;
- l'empilement du support et du convertisseur maintenu sous pression, ladite première face du convertisseur étant en regard dudit support ;
- la réalisation de la première jonction à base de composé d'or et d'indium, par une opération de brasage et de diffusion ;
- ladite opération de brasage et de diffusion comportant les étapes suivantes :
▪ une première étape de montée en température à une première température comprise entre environ 150°C et environ 400°C et le maintien à cette première température pendant une première durée correspondant à un premier palier ;
▪ une deuxième étape de montée en température à une seconde température comprise entre environ 400°C et environ 1000°C et le maintien à cette seconde température pendant une seconde durée correspondant à un second palier.
- l'empilement de l'électrode supérieure sur le convertisseur ;
- la réalisation de la seconde jonction par contact entre le convertisseur et l'électrode supérieure.

3. Procédé de fabrication d'un traducteur ultrasonore haute température selon l'une des revendications 1 ou 2, **caractérisé en ce que** le matériau piézoélectrique est du niobate de lithium.

4. Procédé de fabrication d'un traducteur ultrasonore haute température, selon l'une des revendications 1 à 3, **caractérisé en ce que** le pourcentage atomique de l'indium est inférieur à environ 35 %.

5. Procédé de fabrication d'un traducteur ultrasonore haute température, selon l'une des revendications 3 ou 4, **caractérisé en ce que** le niobate de lithium est un niobate naturel ou un niobate enrichi en isotope 7 du lithium.

6. Procédé de fabrication d'un traducteur ultrasonore haute température, selon l'une des revendications 3 à 5, **caractérisé en ce que** le niobate de lithium présente une coupe d'orientation Z (Y 90°).

7. Procédé de fabrication d'un traducteur ultrasonore haute température, selon l'une des revendications 3 à 5, **caractérisé en ce que** le niobate de lithium présente une coupe d'orientation Y 36° ou une coupe d'orientation Y 163°.

8. Procédé de fabrication d'un traducteur ultrasonore haute température selon l'une des revendications 1 à 7, **caractérisé en ce que** ladite première température est supérieure à la température de fusion de l'indium pur.

9. Procédé de fabrication d'un traducteur ultrasonore haute température selon la revendication 8, **caractérisé en ce que** ladite première température est de l'ordre de 170°C.

10. Procédé de fabrication d'un traducteur selon l'une des revendications 1 à 9, **caractérisé en ce que** ladite seconde température est de l'ordre de 650°C.

11. Procédé de fabrication d'un traducteur selon l'une des revendications 1 à 10, **caractérisé en ce que** la première température est légèrement ascendante durant la première durée.

12. Procédé de fabrication d'un traducteur ultrasonores haute température selon l'une des revendications 1 à 11, **caractérisé en ce que** la première durée est de l'ordre de 1 heure, la seconde durée étant de l'ordre de 2 heures, la montée en température entre ladite première température et ladite seconde température étant de l'ordre de 4 heures.

13. Procédé de fabrication d'un traducteur selon l'une des revendications 1 à 12, **caractérisé en ce que** les étapes de réalisation des jonctions brasées sont effectuées sous un vide secondaire pouvant être de l'ordre de 10⁻⁵ mbar.

14. Procédé de fabrication d'un traducteur selon l'une des revendications 1 à 13, **caractérisé en ce que** les étapes de réalisation des jonctions brasées sont effectuées en maintenant l'assemblage sous une contrainte de pression modérée, qui peut être inférieure à environ 2 kg/cm².

15. Procédé de fabrication d'un traducteur ultrasonore haute température, selon l'une des revendications 1 à 14, **caractérisé en ce qu'**il comprend l'intégration de l'assemblage : support-première jonction-convertisseur-seconde jonction-électrode supérieure dans un boîtier, ledit support étant une lame intégrée audit boîtier.

16. Procédé de fabrication d'un traducteur ultrasonore haute température, selon la revendication 15, **caractérisé en ce que** ledit boîtier comprend des moyens d'aération permettant de renouveler la teneur en oxygène présente dans ledit boîtier.

17. Procédé de fabrication d'un traducteur ultrasonores haute température selon l'une des revendications 1 à 16, **caractérisé en ce qu'**il comprend en outre pour réaliser les jonctions brasées :
- l'assemblage de l'ensemble constitué par l'électrode supérieure, le convertisseur et le support, ou le convertisseur et le support, en présence de feuille intercalée à base d'or et d'indium, ou de mélanges d'or et d'indium, entre chacun des éléments précités ;
- une opération de brasage et diffusion.

18. Procédé de fabrication d'un traducteur selon la revendication 17, **caractérisé en ce qu'**il comprend en outre la réalisation de couches préalables d'or sur les faces desdits éléments destinés à être en regard dans l'opération d'assemblage par brasage, de manière à favoriser l'adhérence desdites feuilles à base d'or et d'indium, ou de mélange d'or et d'indium.

19. Procédé de fabrication d'un traducteur selon l'une des revendications 1 à 18, **caractérisé en ce que** les dépôts de couches sont réalisés par pulvérisation cathodique.

20. Procédé de fabrication d'un traducteur selon l'une des revendications 1 à 19, **caractérisé en ce qu'**il comprend en outre, préalablement aux dépôts de couches d'or, la réalisation de couches d'accrochage sur les faces de l'électrode et/ou du convertisseur et/ou du support.

21. Procédé de fabrication d'un traducteur selon la revendication 20, **caractérisé en ce que** la ou les couches d'accrochage sont à base de chrome et/ou de chrome et de nickel ou de titane.

22. Procédé de fabrication d'un traducteur selon l'une des revendications 1 à 21, **caractérisé en ce qu'**il comprend en outre, le dépôt d'une couche de protection sur la couche d'indium.

23. Procédé de fabrication d'un traducteur selon la revendication 22, **caractérisé en ce que** la couche de protection est à base d'or.

## Patentansprüche

1. Verfahren zur Herstellung eines Hochtemperatur-Ultraschallwandlers, wobei der Wandler eine obere Elektrode (2) aus Stahl oder Metall, einen Konverter (3) aus einem piezoelektrischen Material und ein Substrat (1) aus Stahl oder Metall umfasst, das die Schnittstelle zwischen dem Konverter und dem Schallwellenausbreitungsmedium bildet, einen ersten Übergang (J₁) zwischen dem Substrat und dem piezoelektrischen Material, einen zweiten Übergang (J₂) zwischen dem Konverter und der oberen Elektrode, **dadurch gekennzeichnet, dass** es die folgenden Schritte zur Herstellung der Übergänge beinhaltet:
- Absetzen einer Goldschicht gefolgt vom Absetzen einer Indiumschicht auf eine der Flächen der oberen Elektrode, auf die beiden Flächen des Konverters und auf eine Fläche des Stahlsubstrats;
- Übereinanderschichten des Substrats, des Konverters und der oberen Elektrode unter Druck;
- Realisieren des ersten Übergangs und des zweiten Übergangs auf der Basis von Gold- und Indiumverbindungen mit einem Löt- und Diffusionsvorgang;
- wobei der Löt- und Diffusionsvorgang die folgenden Schritte beinhaltet:
• einen ersten Schritt des Erhöhens der Temperatur auf eine erste Temperatur zwischen etwa 150°C und etwa 400°C und Halten auf dieser ersten Temperatur für eine erste Dauer, die einer ersten Stufe entspricht;
• einen zweiten Schritt des Erhöhens der Temperatur auf eine zweite Temperatur zwischen etwa 400°C und etwa 1000°C und Halten auf dieser zweiten Temperatur für eine zweite Dauer, die einer zweiten Stufe entspricht.

2. Verfahren zur Herstellung eines Hochtemperatur-Ultraschallwandlers, wobei der Wandler Folgendes umfasst: eine obere Elektrode (2) aus Stahl oder Metall, einen Konverter (3) aus piezoelektrischem Material und ein Substrat (1) aus Stahl oder Metall, das die Schnittstelle zwischen dem Konverter und dem Schallwellenausbreitungsmedium bildet, einen ersten Übergang (J₁) zwischen dem Substrat und dem piezoelektrischen Material, einen zweiten Übergang (J₂) zwischen dem Konverter und der oberen Elektrode, **dadurch gekennzeichnet, dass** es darüber hinaus die folgenden Schritte zum Herstellen der Übergänge beinhaltet:
- Absetzen einer Goldschicht gefolgt vom Absetzen einer Indiumschicht auf eine erste Fläche des Konverters und auf eine Fläche des Stahlsubstrats;
- wobei die zweite Fläche des Konverters unabhängig von der Behandlung, die an der Fläche der Elektrode durchgeführt wurde, unbedeckt gelassen oder mit einer Goldschicht gefolgt von einer Indiumschicht oder mit einer Goldschicht oder einer Schicht aus einem anderen Material bedeckt wird, das vorzugsweise nicht oxidierbar ist und dessen elektrische und dielektrische Eigenschaften mit einer elektrischen resistiven und/oder kapazitiven Kopplung beispielsweise des Konverters und der Elektrode durch Kontakt kompatibel sind;
- wobei die Fläche der Elektrode unabhängig von der Behandlung, die an der zweiten Fläche des Konverters durchgeführt wird, unbedeckt gelassen oder mit einer Goldschicht gefolgt von einer Indiumschicht oder mit einer Goldschicht oder einer Schicht aus einem anderen Material bedeckt wird, das vorzugsweise nicht oxidierbar ist und dessen elektrische und dielektrische Eigenschaften mit einer elektrischen resistiven und/oder kapazitiven Kopplung beispielsweise der Elektrode und des Konverters durch Kontakt kompatibel sind;
- Übereinanderschichten des Substrats und des Konverters unter Druck, wobei die erste Fläche des Konverters gegenüber dem Substrat gehalten wird;
- Realisieren des ersten Übergangs auf der Basis einer Gold- und Indiumverbindung durch einen Löt- und Diffusionsvorgang;
- wobei der Löt- und Diffusionsvorgang die folgenden Schritte beinhaltet:
• einen ersten Schritt des Erhöhens der Temperatur auf eine erste Temperatur zwischen etwa 150°C und etwa 400°C und Halten auf dieser ersten Temperatur für eine erste Dauer, die einer ersten Stufe entspricht;
• einen zweiten Schritt des Erhöhens der Temperatur auf eine zweite Temperatur zwischen etwa 400°C und etwa 1000°C und Halten auf dieser zweiten Temperatur für eine zweite Dauer, die einer zweiten Stufe entspricht;
- Übereinanderschichten der oberen Elektrode auf den Konverter;
- Realisieren des zweiten Übergangs durch Kontakt zwischen dem Konverter und der oberen Elektrode.

3. Verfahren zur Herstellung eines Hochtemperatur-Ultraschallwandlers nach Anspruch 1 oder 2, **dadurch gekennzeichnet, dass** das piezoelektrische Material Lithiumniobat ist.

4. Verfahren zur Herstellung eines Hochtemperatur-Ultraschallwandlers nach einem der Ansprüche 1 bis 3, **dadurch gekennzeichnet, dass** der atomare Prozentanteil von Indium kleiner als etwa 35 % ist.

5. Verfahren zur Herstellung eines Hochtemperatur-Ultraschallwandlers nach Anspruch 3 oder 4, **dadurch gekennzeichnet, dass** das Lithiumniobat ein natürliches Niobat oder ein mit Isotop 7 von Lithium angereichertes Niobat ist.

6. Verfahren zur Herstellung eines Hochtemperatur-Ultraschallwandlers nach einem der Ansprüche 3 bis 5, **dadurch gekennzeichnet, dass** das Lithiumniobat in einer Z-Orientierung (Y 90°) geschnitten wird.

7. Verfahren zur Herstellung eines Hochtemperatur-Ultraschallwandlers nach einem der Ansprüche 3 bis 5, **dadurch gekennzeichnet, dass** das Lithiumniobat in einer Orientierung Y 36° oder einer Orientierung Y 163° geschnitten wird.

8. Verfahren zur Herstellung eines Hochtemperatur-Ultraschallwandlers nach einem der Ansprüche 1 bis 7, **dadurch gekennzeichnet, dass** die erste Temperatur höher ist als die Fusionstemperatur des reinen Indiums.

9. Verfahren zur Herstellung eines Hochtemperatur-Ultraschallwandlers nach Anspruch 8, **dadurch gekennzeichnet, dass** die erste Temperatur in der Größenordnung von 170°C liegt.

10. Verfahren zur Herstellung eines Wandlers nach einem der Ansprüche 1 bis 9, **dadurch gekennzeichnet, dass** die zweite Temperatur in der Größenordnung von 650°C liegt.

11. Verfahren zur Herstellung eines Wandlers nach einem der Ansprüche 1 bis 10, **dadurch gekennzeichnet, dass** die erste Temperatur während der ersten Dauer leicht ansteigt.

12. Verfahren zur Herstellung eines Hochtemperatur-Ultraschallwandlers nach einem der Ansprüche 1 bis 11, **dadurch gekennzeichnet, dass** die erste Dauer in der Größenordnung von 1 Stunde liegt, die zweite Dauer in der Größenordnung von 2 Stunden liegt, der Temperaturanstieg zwischen der ersten Temperatur und der zweiten Temperatur in der Größenordnung von 4 Stunden liegt.

13. Verfahren zur Herstellung eines Wandlers nach einem der Ansprüche 1 bis 12, **dadurch gekennzeichnet, dass** die Schritte zum Herstellen der gelöteten Übergänge unter einem sekundären Vakuum durchgeführt werden, das in der Größenordnung von 10⁻⁵ mbar liegen kann.

14. Verfahren zur Herstellung eines Wandlers nach einem der Ansprüche 1 bis 13, **dadurch gekennzeichnet, dass** die Schritte zum Herstellen der gelöteten Übergänge unter Halten des Montagevorgangs unter einer mäßigen Druckbelastung durchgeführt werden, die kleiner als etwa 2 kg/cm² sein kann.

15. Verfahren zur Herstellung eines Hochtemperatur-Ultraschallwandlers nach einem der Ansprüche 1 bis 14, **dadurch gekennzeichnet, dass** es die Integration des Verbands: Substrat - erster Übergang - Konverter - zweiter Übergang - obere Elektrode in ein Gehäuse beinhaltet, wobei das Substrat eine in das Gehäuse integrierte Platte ist.

16. Verfahren zur Herstellung eines Hochtemperatur-Ultraschallwandlers nach Anspruch 15, **dadurch gekennzeichnet, dass** das Gehäuse Lüftungsmittel umfasst, die es zulassen, den in dem Gehäuse vorliegenden Sauerstoffgehalt zu erneuern.

17. Verfahren zur Herstellung eines Hochtemperatur-Ultraschallwandlers nach einem der Ansprüche 1 bis 16, **dadurch gekennzeichnet, dass** es darüber hinaus zur Herstellung der gelöteten Übergänge Folgendes beinhaltet:
- Zusammenfügen der Baugruppe bestehend aus oberer Elektrode, Konverter und Substrat oder Konverter und Substrat in Anwesenheit einer zwischen die jeweiligen oben erwähnten Elemente gelegten Folie auf der Basis von Gold und Indium oder Gemischen von Gold und Indium;
- einen Löt- und Diffusionsvorgang.

18. Verfahren zur Herstellung eines Wandlers nach Anspruch 17, **dadurch gekennzeichnet, dass** er darüber hinaus die Herstellung von Goldvorschichten auf den Flächen der Elemente beinhaltet, die in dem Lötmontagevorgang einander gegenüber liegen sollen, um das Anhaften der Folien auf der Basis von Gold und Indium oder des Gemischs aus Gold und Indium zu begünstigen.

19. Verfahren zur Herstellung eines Wandlers nach einem der Ansprüche 1 bis 18, **dadurch gekennzeichnet, dass** das Absetzen der Schichten durch kathodische Zerstäubung erfolgt.

20. Verfahren zur Herstellung eines Wandlers nach einem der Ansprüche 1 bis 19, **dadurch gekennzeichnet, dass** es darüber hinaus vor dem Absetzen der Goldschichten die Realisierung von Verankerungsschichten an den Flächen der Elektrode und/oder des Konverters und/oder des Substrats beinhaltet.

21. Verfahren zur Herstellung eines Wandlers nach Anspruch 20, **dadurch gekennzeichnet, dass** die Verankerungsschicht(en) auf Chrom und/oder Chrom und Nickel oder Titan basiert/basieren.

22. Verfahren zur Herstellung eines Wandlers nach einem der Ansprüche 1 bis 21, **dadurch gekennzeichnet, dass** es darüber hinaus das Absetzen einer Schutzschicht auf die Indiumschicht beinhaltet.

23. Verfahren zur Herstellung eines Wandlers nach Anspruch 22, **dadurch gekennzeichnet, dass** die Schutzschicht auf Gold basiert.

## Claims

1. Method for producing a high-temperature ultrasonic transducer, the transducer comprising an upper electrode (2) of steel or metal, a converter (3) of piezoelectric material and a support (1) of steel or metal which ensures the interface between the converter and the propagation medium of the acoustic waves, a first joint (J₁) between the support and the piezoelectric material, a second joint (J₂) between the converter and the upper electrode, **characterized in that** it comprises the following steps in order to carry out the joints:
- depositing a layer of gold followed by depositing a layer of indium on one of the faces of the upper electrode, on the two faces of the converter and on one face of the steel support;
- stacking the support of the converter, and the upper electrode, retained under pressure;
- the production of the first joint and the second joint based on components of gold and indium, by means of a brazing and diffusion operation;
- the brazing and diffusion operation comprising the following steps:
• a first step of increasing the temperature to a first temperature between approximately 150°C and approximately 400°C and maintaining it at this first temperature for a first period of time corresponding to a first level;
• a second step of increasing the temperature to a second temperature between approximately 400°C and approximately 1000°C and maintaining it at this second temperature for a second period of time corresponding to a second level.

2. Method for producing a high-temperature ultrasonic transducer, the transducer comprising an upper electrode (2) of steel or metal, a converter (3) of piezoelectric material and a support (1) of steel or metal which ensures the interface between the converter and the propagation medium of the acoustic waves, a first joint (J₁) between the support and the piezoelectric material, a second joint (J₂) between the converter and the upper electrode, **characterized in that** it further comprises the following steps in order to carry out the joints:
- depositing a layer of gold followed by depositing a layer of indium on a first face of the converter and on a face of the steel support;
- the second face of the converter, regardless of the processing carried out on the face of the electrode, being left exposed or covered with a layer of gold followed by a layer of indium or covered with a layer of gold, or any other material, which is preferably non-oxidisable, and whose electrical and dielectric properties are compatible with a resistive and/or capacitive electrical coupling, for example, of the converter and the electrode, by means of contact;
- the face of the electrode, regardless of the processing carried out on the second face of the converter, being able to be left exposed or covered with a layer of gold followed by a layer of indium or covered with a layer of gold, or any other material, which is preferably non-oxidisable and whose electrical and dielectric properties are compatible with a resistive and/or capacitive electrical coupling, for example, of the electrode and the converter, by means of contact;
- the stacking of the support and the converter retained under pressure, the first face of the converter being opposite the support;
- the production of the first joint based on a compound of gold and indium, by means of a soldering and diffusion operation;
- the brazing and diffusion operation comprising the following steps:
• a first step of increasing the temperature to a first temperature between approximately 150°C and approximately 400°C and maintaining it at this first temperature for a first period of time corresponding to a first level;
• a second step of increasing the temperature to a second temperature between approximately 400°C and approximately 1000°C and maintaining it at this second temperature for a second period of time corresponding to a second level,
- the stacking of the upper electrode on the converter;
- the production of the second joint by means of contact between the converter and the upper electrode.

3. Method for producing a high-temperature ultrasonic transducer according to either claim 1 or claim 2, **characterised in that** the piezoelectric material is lithium niobate.

4. Method for producing a high-temperature ultrasonic transducer according to any one of claims 1 to 3, **characterised in that** the atomic percentage of the indium is less than approximately 35%.

5. Method for producing a high-temperature ultrasonic transducer according to either claim 3 or claim 4, **characterised in that** the lithium niobate is a natural niobate or a niobate which is enriched with isotope 7 of lithium.

6. Method for producing a high-temperature ultrasonic transducer according to any one of claims 3 to 5, **characterised in that** the lithium niobate has an orientation cross-section Z (Y 90°).

7. Method for producing a high-temperature ultrasonic transducer according to any one of claims 3 to 5, **characterised in that** the lithium niobate has an orientation cross-section Y 36° or an orientation cross-section Y 163°.

8. Method for producing a high-temperature ultrasonic transducer according to any one of claims 1 to 7, **characterised in that** the first temperature is greater than the fusion temperature of pure indium.

9. Method for producing a high-temperature ultrasonic transducer according to claim 8, **characterised in that** the first temperature is in the order of 170°C.

10. Method for producing a transducer according to any one of claims 1 to 9, **characterised in that** the second temperature is in the order of 650°C.

11. Method for producing a transducer according to any one of claims 1 to 10, **characterised in that** the first temperature increases slightly during the first period of time.

12. Method for producing a high-temperature ultrasonic transducer according to any one of claims 1 to 11, **characterised in that** the first period of time is in the order of 1 hour, the second period of time being in the order of two hours, the increase in temperature between the first temperature and the second temperature being in the order of 4 hours.

13. Method for producing a transducer according to any one of claims 1 to 12, **characterised in that** the steps for producing the soldered joints are carried out under a secondary pressure reduction which may be in the order of 10⁻⁵ mbar.

14. Method for producing a transducer according to any one of claims 1 to 13, **characterised in that** the steps for producing the soldered joints are carried out with the assembly being maintained under a stress of moderate pressure which may be less than approximately 2 kg/cm².

15. Method for producing a high-temperature ultrasonic transducer according to any one of claims 1 to 14, **characterised in that** it comprises the integration of the assembly: support/first joint/converter/second joint/upper electrode in a casing, the support being a plate which is integrated in the casing.

16. Method for producing a high-temperature ultrasonic transducer according to claim 15, **characterised in that** the casing comprises ventilation means which allow the oxygen content which is present in the casing to be renewed.

17. Method for producing a high-temperature ultrasonic transducer according to any one of claims 1 to 16, **characterised in that** it further comprises in order to carry out the soldered joints:
- the assembly of the whole which is constituted by the upper electrode, the converter and the support, or the converter and the support, in the presence of an interposed sheet based on gold and indium, or admixtures of gold and indium, between each of the above-mentioned elements;
- a brazing and diffusion operation.

18. Method for producing a transducer according to claim 17, **characterised in that** it further comprises the production of prior layers of gold on the faces of the elements which are intended to face each other in the assembly operation by means of brazing, in order to promote the adhesion of the sheets based on gold and indium, or an admixture of gold and indium.

19. Method for producing a transducer according to any one of claims 1 to 18, **characterised in that** the deposits of layers are produced by means of cathode sputtering.

20. Method for producing a transducer according to any one of claims 1 to 19, **characterised in that** it further comprises, prior to the deposits of layers of gold, the production of fastening layers on the faces of the electrode and/or the converter and/or the support.

21. Method for producing a transducer according to claim 20, **characterised in that** the fastening layer(s) is/are based on chromium and/or chromium and nickel or titanium.

22. Method for producing a transducer according to any one of claims 1 to 21, **characterised in that** it further comprises the deposit of a protection layer on the layer of indium.

23. Method for producing a transducer according to claim 22, **characterised in that** the protection layer is based on gold.
